Europäisches Patentamt

European Patent Office

Office européen des brevets

(11) Publication number: **0 178 227 B1**

# EUROPEAN PATENT SPECIFICATION

(45) Date of publication of patent specification: **12.07.89**

(21) Application number: **85401948.6**

(22) Date of filing: **04.10.85**

(51) Int. Cl.⁴: **H 01 L 27/04, H 01 L 23/52**

(54) Integrated circuit semiconductor device formed on a wafer.

(30) Priority: **05.10.84 JP 209238/84**

(43) Date of publication of application:
**16.04.86 Bulletin 86/16**

(45) Publication of the grant of the patent:
**12.07.89 Bulletin 89/28**

(84) Designated Contracting States:
**DE FR GB**

(56) References cited:
**FR-A-2 382 101**

**PATENT ABSTRACTS OF JAPAN, vol. 6, no. 55
(E-101)933r, 10th April 1982 & JP-A-56 167 355**

(73) Proprietor: **FUJITSU LIMITED
1015, Kamikodanaka Nakahara-ku
Kawasaki-shi Kanagawa 211 (JP)**

(72) Inventor: **Tanizawa, Tetsu
7-1-301, Hosoyama 1 chome
Asao-ku Kawasaki-shi Kanagawa 215 (JP)**

(74) Representative: **Descourtieux, Philippe et al
CABINET BEAU de LOMENIE 55 rue
d'Amsterdam
F-75008 Paris (FR)**

Courier Press, Leamington Spa, England.

## Description

### BACKGROUND OF THE INVENTION

The present invention relates to a large scale integrated circuit (LSI) semiconductor device, more precisely, to a very large scale integrated (VLSI) circuit semiconductor device wherein the entire area of a semiconductor wafer or slice is used for fabricating the circuit. It is especially concerned with a device permitting the wafer or the slice containing some defects in order to increase production yield of the device.

Recently, the integration scale of LSI circuits has been increasing and their chip size has also become larger. It has then been tried to make VLSI circuits by using the entire area of the wafer or slice (hereinafter referred to simply as a wafer), such circuits being called wafer integration circuits or wafer ICs. But the most serious problem encountered is the fabricating yield, because no defect is allowed in the wafer to complete the device.

Many attempts to overcome the above difficulties and to realize wafer ICs have been made by semiconductor manufacturers. For example, among a number of chips formed in a wafer, only the good are selected, and are connected to each other to form a VLSI, without separating the chips from the wafer. By this method, the problem of defects on the wafer can be overome. Such method is suitable for a VLSI which includes a plurality of same circuitries, such as a memory device. However, the number of and the types of the chips included in the wafer are limited, because the number of chips in the wafer must be redundant for each type of chip. Accordingly, it cannot be considered as a real wafer IC.

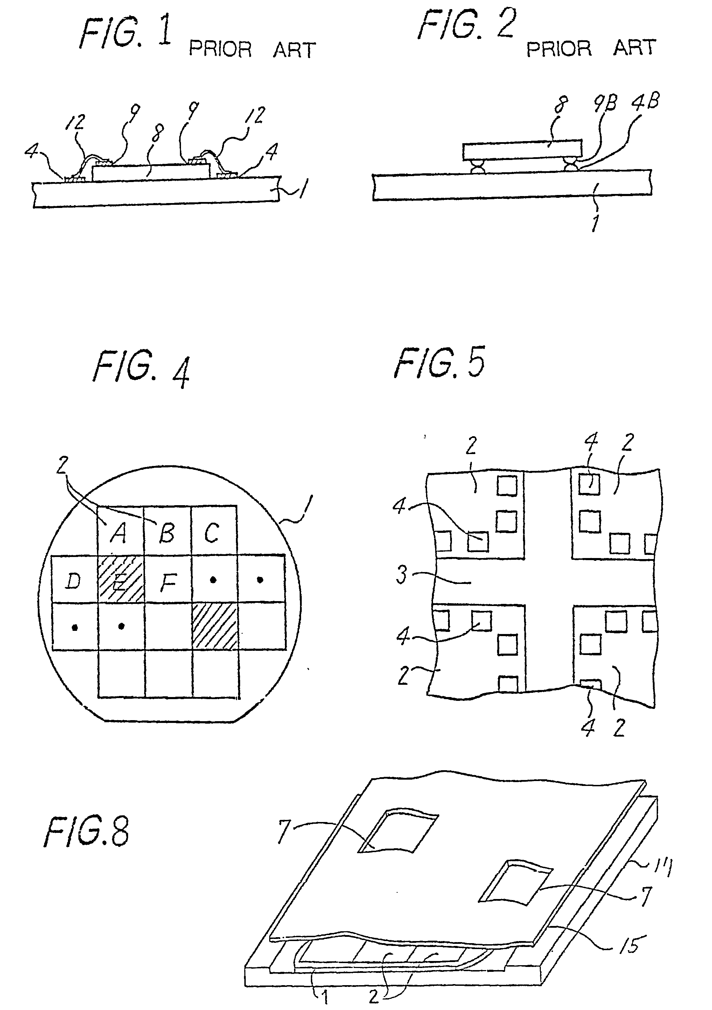

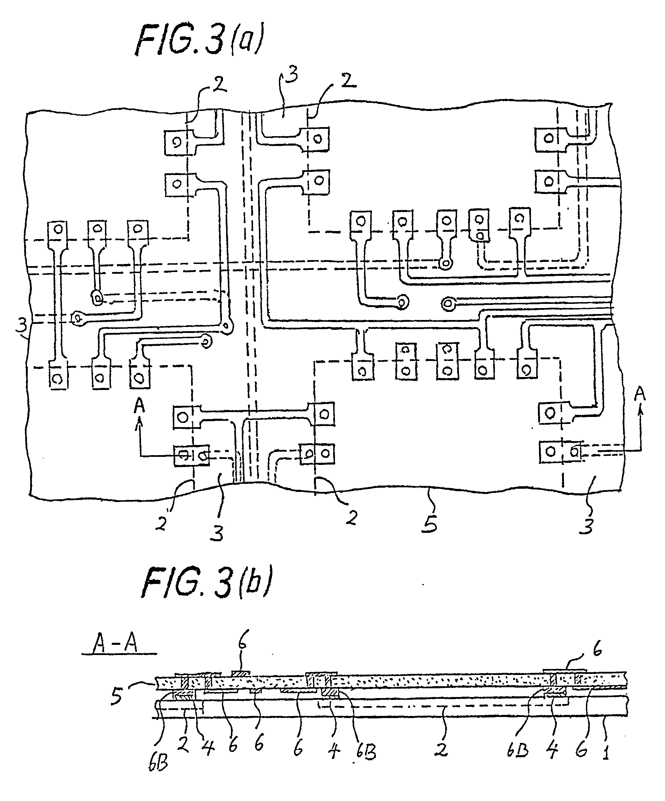

Another attempt consists in replacing a defective chip or portion by a good one. According to one approach, a good chip 8, namely a repair chip, is piled on the bad chip or bad portion in the wafer 1, as shown in Fig. 1, and bonding pads 9 on the repair chip 8 are connected to bonding pads 4 on the wafer 1, using bonding wires 12. According to another approach, as shown in Fig. 2, bonding bumps 9B of a repair chip 8 are bonded to bumps 4B formed on the bad portion, in a face-down bonding.

In all of the above attempts, since the good chips selected in the wafer are distributed on the wafer 1 in a random manner, the bondings between the chips differs from wafer to wafer and from point to point of defect. Accordingly, the spare chips for replacing the bad chips or bad portions thereof must be prepared for all the anticipated defects in the wafer. This is quite undesirable for mass production. Moreover, it is required to develop an additional technology to cut off the bad chip or the bad portion electrically from the wafer and bond a new chip in the same position. Therefore, at the present moment, it is still not practical to fabricate wafer IC devices in large quantity by the state-of-the-art technology.

### SUMMARY OF THE INVENTION

An object of the present invention, therefore, is to realize a VLSI semiconductor device having a scale extending over the entire area of a wafer, namely a wafer IC.

Another object of the present invention is to provide a standardized structure of a wafer IC suitable for wiring between good chips in the wafer and repair chips replacing defective chips contained in the wafer.

A further object of the present invention is to realize a wafer IC device suitable for production in large quantity.

In order to attain the above objects, the present invention provides an integrated circuit semiconductor device comprising:

a semiconductor wafer having a plurality of circuit blocks formed therein and an intermediate area formed in said semiconductor wafer between said circuit blocks, electrically isolating said circuit blocks from each other; and

an interconnecting film comprising an insulating film and an interconnecting circuit formed on a surface of said insulative film,

said interconnecting film being placed on said semiconductor wafer in alignment with each other, and said interconnecting circuit being connected to said circuit blocks to complete said integrated circuit semiconductor device.

Thus, the present invention provides a VLSI circuit having a plurality of circuit blocks. Each of the circuit blocks is allotted to one of circuit block areas in the wafer which correspond to chip areas in an ordinary LSI wafer. In a preferred embodiment, each of the circuit block areas has the same predetermined size, being arranged in a matrix fashion just as in an ordinary LSI wafer. Furthermore, according to a further preferred embodiment each one of the circuit block areas has the same bonding bumps arranged on its periphery in the same predetermined layout pattern. Thus, the appearance or the pattern of the circuit block areas is the same as that of ordinary LSI wafers. The difference between the wafer IC and the ordinary LSI wafer lies in that each of the circuit block areas has circuit blocks different from each other, while each of the circuit block areas in an ordinary LSI wafer has the same circuit block.

The spacing between the circuit block areas of the wafer IC is also used for an object different from that in an ordinary LSI wafer. In the latter, the spacing is used for cutting the chips away from each other to make individual LS chips, therefore, the spacing is referred to as a scribing space. While, in the former, the spacing is left blank, being used for electrically isolating the circuit blocks from each other. The wiring for interconnecting the circuit blocks to each other, or for connecting the circuit blocks to input/output terminals of the relevant package is provided on another insulative layer placed on the wafer as described later. Therefore, hereinafter, the spacing is referred to simply as an intermediate area. At this stage, the circuit blocks formed in the wafer are electrically isolated from each other.

This serves to make it possible to check each one of the circuit blocks for detecting defective circuit blocks more easily than by checking the whole circuit after the circuit blocks have been interconnected as in the case of an ordinary wafer IC, because the circuit of each block has a fairly small scale and is easily accessible by a testing apparatus. In most cases, a computer aided testing method is applicable to the test increasing the testing efficiency. This is one of the merits of the present invention.

A distinguishing feature of the present invention lies in the interconnecting wiring method used. The wiring is not performed directly. No interconnecting wiring is formed on the wafer. The interconnecting wiring is provided by wiring patterns formed on an insulative film piled on the wafer. The wiring pattern has bonding pads corresponding to bonding bumps, for instance, provided on the wafer in a predetermined layout pattern. The insulative film is placed on the wafer and aligned with respect to the pattern on the wafer so that the bonding pads on the insulative film contact the corresponding bonding bumps in a face-to-face relationship. Thereafter, the facing pad and bump are bonded to each other.

Interconnection of semiconductor devices by means of insulating films provided with interconnecting wiring layers is already known from FR-A-2 382 101.

A significant advantage of the present invention lies in the wiring method used when some of the circuit blocks in the wafer have defects and should be replaced with repair chips. The circuit blocks on the wafer are tested individually before they are wired, using a testing apparatus, desirably a computer aided testing apparatus. If a circuit block is rejected by the testing, the defective circuit block is replaced by a repair chip. This is made by bonding a repair chip on the defective circuit block first. On the repair chip, a circuit is formed beforehand which is the same as that of the defective circuit block. When the repair chip is bonded on the wafer, the pattern on the repair chip is aligned with respect to the pattern on the wafer. Therefore, after the alignment of the repair chip, the plan view of the entire wafer is just the same as that of the original wafer, except the protrusion of the top surface of the repair chip, where bonding pads are disposed in a predetermined pattern. The wiring of a repair chip to the relevant portion can be carried out in two different manners which differ from each other only in the way of overcoming the protruded top surface of the repair chip.

In the first embodiment, the bonding structure contains two insulative films, a first film and a second film, having wiring patterns respectively formed thereon. The interconnecting wiring (circuits) formed on the first insulative film are arranged selectively on the portion which is to be placed just on the intermediate area of the wafer. The portions of the first insulative film corresponding to defective circuit blocks are punched off. The size of each punched off area is determined to be slightly larger than that of the corresponding circuit block, so that the subsequent alignment of the first insulative film, namely, the remainder part of the interconnecting circuit pattern, with the pattern of the wafer can be performed without being affected by the repair chips already bonded to the wafer. Then the circuit pattern is bonded to the wafer leaving the repair chips unconnected. Since the shape and size of the circuit block areas and the bonding pads provided thereon are equal for all the circuit block areas, it is unnecessary to vary the type of tip of the punch head used to punch off the insulative film, no matter where the defect on the wafer is located.

The repair chip bonded on the defective circuit block has a top surface which protrudes from that of the first insulative film. A second insulative film, a repair insulative film, is placed on the repair chip, having a second wiring pattern which connects the bonding pads of the repair chip to the interconnecting circuit pattern provided on the first insulative film. The second wiring pattern, referred to as a connecting pattern, has two kinds of layout patterns of bonding pads: one is the same predetermined layout pattern as that of the pads of circuit blocks, and the other is another predetermined layout pattern for the pads connecting the circuit pattern on the first insulative film to that on the second insulative film, having a larger layout pattern than the circuit block on the wafer.

Thus, by bonding the second wiring pattern provided on the second insulative film to the first wiring pattern provided on the first insulative film, the bonding of the repair chip to the interconnecting circuit is completed. As mentioned above, the bonding pads and their layout on the circuit block area are the same for all the circuit blocks; the second wiring pattern on the second insulative film can then be applied to any circuit block, no matter where it is located. This is another merit of the present invention.

The second embodiment of the method for wiring a repair chip is rather simpler than the first one. It utilizes the flexibility of the insulative film. The flexibility of an interconnecting insulative film provided with a plurality of wiring pattern layers and which wraps an LSI chip placed on a wiring substrate is already known from JP-A- 56167355. Since the layout pattern of the bonding pads on the wafer having repair chips bonded thereon is the same as that of a non-repaired wafer, a flexible insulative film having the same circuit pattern as that of the film in the above first embodiment can be used. The flexible insulative film is placed on the mended wafer, and the bonding pads on the wafer are aligned with and bonded to the wiring pattern of the flexible insulative film, whereby protruding top surfaces of the repair chip are accommodated to by the deformation of the insulative film.

Still another merit of the present invention lies in the preparation of spare chips reserved for the use as repair chips when some mending is required. If there are circuit blocks of n kinds on the wafer, it is necessary to prepare repair chips of n kinds for repairing defects at any part of the wafer. But it will be understood for the one in the art, that there occurs frequently wafers having too many defects to be repaired therein. Such wafers are scribed like ordinary LSI chips, and good chips are selected and classified according to the type of circuit block to be stored as repair chips. Therefore, it is unnecessary to specially fabricate repair chips of n kinds. Consequently, a rejected wafer can be reused for preparing repair chips, further increasing the total production yield of the wafer ICs.

These, together with other objects and advantages of the invention will be more readily apparent from the foregoing description made with reference to the accompanying drawings, wherein same reference numerals refer to identical or similar parts.

BRIEF DESCRIPTION OF THE DRAWINGS

Figs. 1 and 2 are partial schematic side views of a wafer IC, illustrating two prior art repairing methods wherein a defective circuit block is replaced by a good one, namely a repair chip,

Fig. 3(a) is a partial plan view of an embodiment of a non-defective wafer IC according to the present invention, illustrating its basic configuration,

Fig. 3(b) is a partial cross-sectional view of the wafer IC of Fig 3(a),

Fig. 4 is a schematic plan view of a wafer IC, illustrating the arrangement of its circuit blocks,

Fig. 5 is a schematic partial plan view of a circuit block, illustrating the arrangement of bonding pads formed thereon,

Fig. 6(a) is a partial plan view of an embodiment of a wafer IC containing a defective circuit block and a repair chip bonded thereon, illustrating a first repairing structure,

Fig. 6(b) is a partial cross-sectional view of the wafer IC of Fig. 6(a),

Fig. 7(a) is a partial plan view of an embodiment of a wafer IC containing a defective circuit block and a repair chip bonded thereon, illustrating another repairing structure,

Fig. 7(b) is a partial cross-sectional view of the wafer IC of Fig. 7(a), and

Fig. 8 is a perspective view of the embodiment of Fig. 7(a) and Fig. 7(b), illustrating the relative arrangement of a metal base, a wafer and an interconnecting film.

DESCRIPTION OF THE PREFERRED EMBODIMENTS

The first embodiment is illustrated in Fig. 3(a) in a magnified partial plan view and in Fig. 3(b) in cross-sectional view along the lines A-A of Fig. 3(a).

A wafer IC according to the present invention comprises a silicon wafer 1 and an interconnecting film. A plurality of circuit blocks 2 are formed in a matrix arrangement in the silicon wafer 1 by conventional IC technology. The areas for the circuit blocks 2 are represented with dotted lines in Fig. 3(a). A schematic plan view of the wafer 1 is also illustrated in Fig. 4, representing circuit blocks 2 designated by A, B, C, D, etc. An intermediate area 3 occupying the surface of the wafer 1 between the circuit blocks 2, as shown in Fig. 3(a), is a blank region wherein no wiring pattern is formed, thus electrically separating the circuit blocks 2 from each other. This enables each circuit block 2 to be accessed for testing at this fabrication stage very easily, because the scale of the circuit contained in each circuit block 2 is fairly simple and can be tested by using an automatic computer aided testing system.

Each circuit block 2 has pads 4 in its peripheral area as shown schematically in Fig. 5. The pads are arranged in a predetermined layout pattern. The type of the layout pattern is not always limited to be only one type. Layout patterns of two or three types, for example, can be also employed depending on the circuit design. Particularly, when only one pattern of circuit blocks 2 is adopted for standardization, various benefits of the fabrication process can be obtained, as it will be shown later. However, according to requirements of design, the circuits contained in the circuit blocks 2 may be different from one another.

The circuit blocks are connected to each other by means of an interconnecting film comprising an insulative film 5 made of a macromolecular compound, such as polyimide material, having a thickness comprised between about 10 μm and 100 μm and an interconnecting circuit pattern 6. The circuit pattern 6 comprising various interconnecting circuits may be formed both on the top surface and rear surface of the insulative film 5, the connections between the two parts of the circuit pattern 6 being then achieved by means of conductive through-holes formed in the insulative film 5. The material and technology used for forming the circuit pattern 6 are conventional ones, the pattern 6 being for example in the form of an etched copper foil circuit pattern. Herein, the rear surface represents the surface to be placed in face to face relationship with the surface of the wafer, and the top surface is the opposite surface.

The circuit pattern 6 is formed usually on the portion of the top and/or rear surfaces of the insulative film 5 just above the intermediate area 3 of the wafer 1. However this limitation is not always necessary (except for the third embodiment which is described hereinafter). The circuit pattern 6 formed on the insulative film 5 has also bonding pads 6B disposed on the rear surface thereof, corresponding to the pads 4 of the circuit blocks 2 of the wafer 1.

Then, the wafer 1 is bonded on a base (not shown but being similar to the metal base 14 shown in Fig. 8). The interconnecting film is placed on the wafer 1 in alignment therewith, and each corresponding pads 4 and 6B are bonded to each other by a conventional method such as supersonic bonding. Thus, the wafer IC is completed.

As described before, a wafer IC, usually, cannot be free from several defects due to crystal defects of the silicon wafer 1 or fabrication faults of circuit blocks 6. These defects are located at random as indicated by hatched squares in Fig. 4. Thus, defective portions or defective circuit blocks are detected by electrical testing just after the completion of the circuit blocks 6 formed therein, and must be replaced with good ones, namely repair chips 8, prepared in advance. This replacement is inevitable at present moment. The most significant feature of the present invention is that such replacement of the defective circuit blocks can be performed without troublesome reworks of the associated portions of the interconnecting circuits. Two embodiments of a repaired wafer IC according to the present invention will be now described.

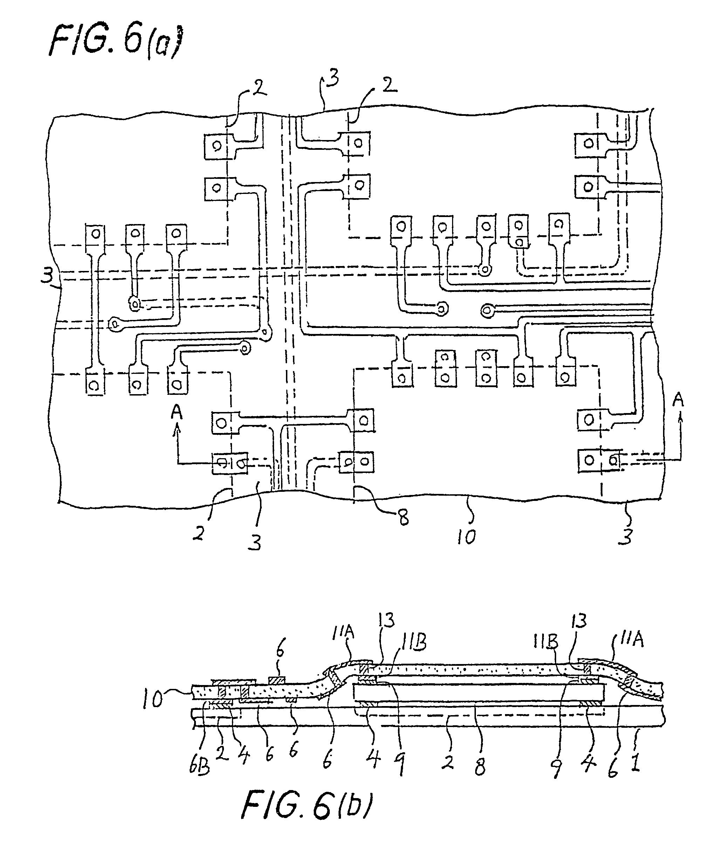

Fig. 6(a) and Fig. 6(b) are respectively a plan view and a cross-sectional view partially illustrating a portion of a wafer IC containing a replaced repair chip 8. The basic difference between this embodiment and the one of Figs. 3(a), 3(b) resides in the provision of an interconnecting film with an insulative film 10 showing a sufficient flexibility to accomodate with the protruding top surface of the repair chip 8 bonded on a defective circuit block 2 of the wafer 1 for replacement. The material of the insulative film 10 is selected from macromolecular plastic materials such as polyimide plates used for conventional flexible printed circuit sheets. A transparent one is more suitable because a visual alignment of the pattern of the insulative film 10 with that of the wafer 1 is permitted.

An aluminum base is attached to the rear surface of the wafer 1 in a way similar to the one shown in Fig. 8. Thereafter, as shown in Fig. 6(b), the repair chip 8 is bonded to the pads 4 of a defective circuit block by a conventional method. Naturally, the top surface of the repair chip 8 protrudes from the surface of the wafer 1. The protruding top surface is accommodated to by the deformation of the insulative film 10, and the connection between the pads 9 of the repair chip 8 and the bonding means 11B, such as bonding bumps, of the interconnecting circuit is performed in the same manner as for the embodiment of Figs. 3(a), 3(b). Thus, the circuit blocks 2 including the repair chip 8 are connected to the interconnecting circuit pattern 6.

When a repair chip 8 has an uninsulated portion, such as the side walls of its scribed substrate, a specially designed bonding means is prepared for connecting the repair chip 8 to avoid electrical shortage through the substrate of the repair chip. In the cross-sectional view of Fig. 6(b), an example of the above bonding mechanism is illustrated. A bonding bump 11B corresponding to a pad 9 of the repair chip 8 is formed on the rear surface of the insulative film 10. The bonding bump 11B is connected to a conductor (wiring) 11A on the top surface of the insulative film 10 through a through-hole 13, thus leaving a non-wired (blank) portion on the rear surface of the insulative film 10 around the repair chip 8. As a result, the substrate of the repair chip 8 is kept apart from conductive members when the insulative film 10 is placed on the repair chip 8 and deformed towards the wafer surface. This structure of bonding means is used when a repair chip is prepared from a wafer IC containing too many defects: the wafer is scribed so that the circuit blocks 2 are divided into individual chips and good chips are selected to be used as repair chips whose scribed side walls are exposed and not insulated.

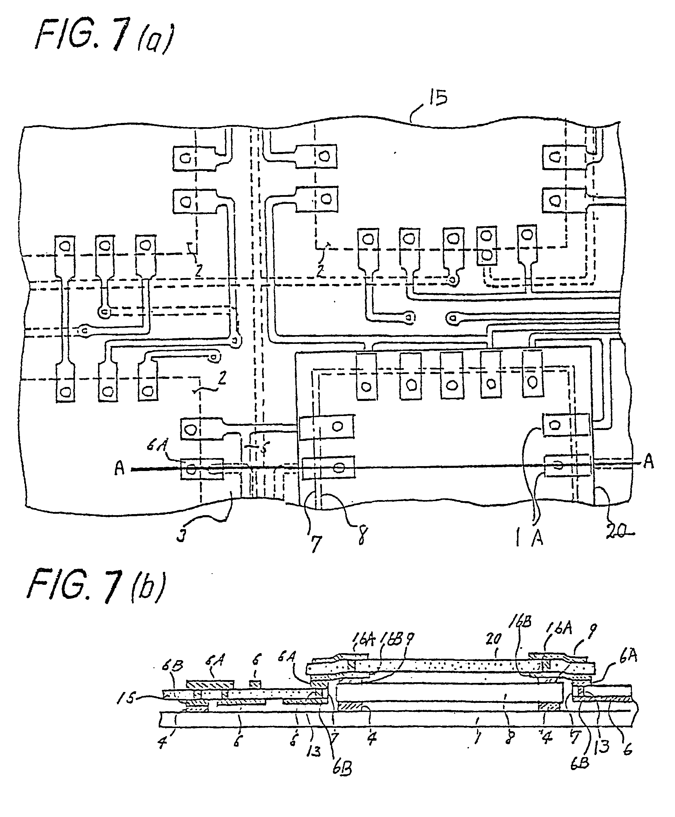

A further embodiment of a wafer IC according to the invention is illustrated in plan view in Fig.7(a) and in cross-sectional view in Fig. 7(b). The wafer IC comprises a wafer 1, an interconnecting film and a repair film. The interconnecting film consists of an insulative film 15 and interconnecting circuit patterns 6 formed selectively on the portion of the insulative film 15 corresponding to the intermediate area 3 of the wafer 1. The repair film comprises an insulative film 20 and connecting pattern 16 formed thereon as shown in Fig 7(a) and Fig. 7(b).

Defective circuit blocks 2 contained in a wafer 1 are replaced by repair chips 8. The protruding top surfaces of the repair chips 8 are accommodated to in a way different from the one of preceding embodiment. Corresponding to each defective circuit block detected by an intermediate checking, a hole 7 having a size slightly larger than that of the relevant repair chip 8 is opened in the insulative film 15. The hole 7 is represented by dot-dashed lines in Fig. 7(a). When the outer size of the circuit blocks 2, and therefore that of the corresponding repair chips 8, is determined according to one standard dimension, a punching head of a single size can be used commonly for opening the holes 7, and the punching position can be controlled by a computer in which information regarding the location of the defective circuit blocks is stored in advance as a result of the testing of the wafer. Thus, the intermediate checking of the wafer and the location of the punching head are controlled by a computer system, increasing the efficiency of the process.

Bonding pads 6A and 6B are formed on the top and rear surfaces of the insulative film 15 respectively, being connected to each other by means of through-holes 13. The bonding pads 6B are longer than those of the above described other embodiments. The bonding pads 6B extend across the punching line of a hole 7, and have a portion on each side of said line. The portions of the bonding pads 6B located inside the punching line are bonded to the pads 4 of a good circuit block for connecting same to the interconnecting circuit pattern 6. When a hole 7 is punched off in a defective circuit block 2, the portion of the bonding pads 6B within the punching line is lost to isolate the relevant defective circuit block 2 completely from the associated circuits, while the connecting means 16B on the repair film 20 has still two connecting portions due to its larger rectangular shape. As easily understood from Figs. 7(a) and 7(b), the connection between the interconnecting circuit pattern 6 and the repair chip 8 can be performed by the connecting means 168, bridging the pads 9 of the repair chip 8 and the remaining bonding means 6A. Thus the repair chip 8 is connected to the interconnecting circuit to complete the wafer IC. The thickness of the insulative film 15 is desirably selected to be almost equal to that of the repair chip 8, such as 200 µm to 300µm, so that the top surface of the repair chip 8 and that of the repair film 20 are on the same level. When the layout pattern of the pads 4 of the repair chips 8, and that of the bonding means 6B are standardized, a repair film 2D of one standard type can be used commonly, enabling the repair work to be substantially easy.

The insulative film 15 and the repair film 20 are made from macromolecular plastic film such as a polyimide film.

The repair film may not be made only with a small size containing a pair of connecting means to be used for only one repair chip as shown in Figs. 7(a) and 7(b). There can be used a common repair film (not shown in a figure) having a plurality of pairs of connecting means having the same pattern and located in positions corresponding to all the circuit blocks 2 of the wafer 1. Of course, the connecting means on the insulative film are isolated from each other and the connecting means facing defective circuit blocks are used as individual repair film, being bonded to corresponding defective circuit blocks through respective holes 7 formed in the insulative film 15. Such an "integrated" repair film is convenient for handling and alignment of the repair film, particularly when a number of defective circuit blocks exist on the wafer.

## Claims

1. An integrated circuit semiconductor device characterized in that it comprises:
a semiconductor wafer (1) having a plurality of circuit blocks (2) formed therein and an intermediate area (3) formed in said semiconductor wafer between said circuit blocks, electrically isolating said circuit blocks from each other; and
an interconnecting film comprising an insulating film (5; 10; 15) and an interconnecting circuit (6) formed on a surface of said insulative film,
said interconnecting film being placed on said semiconductor wafer in alignment with each other, and said interconnecting circuit being connected to said circuit blocks to complete said integrated circuit semiconductor device.

2. An integrated circuit semiconductor device according to claim 1, characterized in that each of said circuit blocks (2) has a plurality of first bonding means (4) having a predetermined layout pattern thereon, said interconnecting circuit (6) has a plurality of second bonding means (6B) on a surface of said insulative film arranged to correspond to said first bonding means, and said second bonding means are bonded respectively to said corresponding first bonding means, thus connecting said circuit blocks to said interconnecting circuit.

3. An integrated circuit semiconductor device according to any one of claims 1 and 2, characterized in that said circuit blocks are arranged in a matrix fashion and have the same predetermined size.

4. An integrated circuit semiconductor device, characterized in that it comprises:
a semiconductor wafer (1) having a plurality of circuit blocks (2) formed therein containing a defective circuit block and an intermediate area (3) formed in said semiconductor wafer between said circuit blocks, electrically isolating said circuit blocks from each other;
a flexible interconnecting film comprising a flexible insulative film (10) and an interconnecting circuit (6) formed on said flexible insulative film; and
a repair chip (8) bonded on said defective circuit block, said repair chip having a replaceable circuit with that of said defective circuit block,
said flexible interconnecting film being placed on said semiconductor wafer and said repair chip in alignment with each other and said interconnecting circuit being connected to said circuit blocks and to said repair chip to complete said integrated circuit semiconductor device, the protruding top surface of said repair chip being wrapped by said flexible interconnecting film by the aid of the deformation of said flexible insulative film.

5. An integrated circuit semiconductor device according to claim 4, characterized in that each of said circuit blocks (2) and said repair chip (8) has a plurality of first bonding means (4, 9) arranged in a predetermined layout pattern thereon, said interconnecting circuit (6) formed on said flexible insulative film has a plurality of second bonding means (6B, IIB) on a surface of said insulative film corresponding to said first bonding means, and said corresponding first bonding means and said second bonding means are bonded to each other, thus connecting said circuit blocks and said repair chip to said interconnecting circuit.

6. An integrated circuit semiconductor device according to any one of claims 4 and 5, characterized in that said circuit blocks and said repair chip are arranged in a matrix fashion.

7. An integrated circuit semiconductor device characterized in that it comprises:
a semiconductor wafer (1) having a plurality of circuit blocks (2) formed therein containing a defective circuit block and an intermediate area (3) formed in said semiconductor wafer between said circuit blocks, electrically isolating said circuit blocks from each other;
a repair chip (8) bonded on said defective circuit block, said repair chip having a replaceable circuit with that of said defective one;
an interconnecting film comprising an insulative film (15) and an interconnecting circuit (6) formed thereon, said interconnecting film having a hole (7) opened at the location corresponding to said defective circuit block in said semiconductor wafer, said hole having a size slightly larger than that of said repair chip; and

a repair film comprising an insulative film (20) and a plurality of connecting means (16A, 16B) formed on a surface of said insulative film for connecting said repair chip to said interconnecting circuit (6) of said interconnecting film,

said interconnecting film being placed on said semiconductor wafer in alignment with said circuit blocks of said semiconductor wafer, and said interconnecting circuit thereon being connected to said circuit blocks of said semiconductor wafer except said repair chip, and said repair film being placed on said repair chip in alignment therewith for connecting said repair chip to said interconnecting circuit.

8. An integrated circuit semiconductor device according to claim 7, characterized in that each of said circuit blocks and said repair chip has a plurality of first bonding means (4, 9) arranged in a first predetermined layout pattern,

said interconnecting circuit formed on said insulative film has a plurality of second bonding means (6B) arranged in said first predetermined layout pattern corresponding to said first bonding means, and a plurality of third bonding means (6A) arranged in a second predetermined layout pattern, each of said second bonding means being connected to a corresponding one of said third bonding means,

each of said connecting means formed on said repair film comprises a fourth bonding means (16A), fifth bonding means (16B) and a conductor connecting said fourth bonding means to said fifth bonding means, said fourth bonding means being arranged in said first predetermined layout pattern and said fifth bonding means being arranged in said second predetermined layout pattern,

said second bonding means (6B) are bonded to said corresponding first bonding means (4), thus connecting circuit blocks to said interconnecting circuit,

said fourth bonding means (16A) are bonded to said corresponding first bonding means (9) of said repair chip, said fifth bonding means (16B) are bonded to said third bonding means (6A).

9. An integrated circuit semiconductor device according to any one of claims 7 and 8, characterized in that said circuit blocks and said repair chip are arranged in a matrix fashion.

10. An integrated circuit semiconductor device according to any one of claims 7 to 9, characterized in that said interconnecting wiring (6) is formed only on a portion of said surface of said insulating film facing said intermediate area of said wafer.

11. An integrated circuit semiconductor according to any one of claims 8 to 10, characterized in that said repair film has a plurality of said connecting means corresponding to each one of all the circuit blocks of said semiconductor wafer.

12. An integrated circuit semiconductor device according to any one of the preceding claims, characterized in that said insulative film (5; 10; 15) is made of a macromolecular compound such as polyimide.

13. An integrated circuit semiconductor device according to any one of the preceding claims, characterized in that said insulative film (5; 10; 15) is transparent.

**Patentansprüche**

1. Integrierte Halbleiterschaltungsvorrichtung, dadurch gekennzeichnet, daß sie umfaßt:

ein Halbleiterwafer (1), das eine Vielzahl von Schaltungsblöcken (2) hat, die darin gebildet sind, und einen Zwischenbereich (3), der in dem genannten Halbleiterwafer zwischen den genannten Schaltungsblöcken gebildet ist und die genannten Schaltungsblöcke elektrisch voneinander isoliert; und

einen Zwischenverbindungsfilm, der einen isolierenden Film (5; 10; 15) und eine zwischenverbindende Schaltung (6) umfaßt, die auf einer Oberfläche des genannten isolierenden Films gebildet ist,

welcher zwischenverbindende Film auf dem genannten Halbleiterwafer in Ausrichtung miteinander plaziert ist, und welche genannte zwischenverbindende Schaltung mit den genannten Schaltungsblöcken verbunden ist, um die genannte integrierte Halbleiterschaltungsvorrichtung zu vervollständigen.

2. Integrierete Halbleiterschaltungsvorrichtung nach Anspruch 1, dadurch gekennzeichnet, daß jeder der genannten Schaltungsblöcke (2) eine Vielzahl von ersten Verbindungseinrichtungen (4) hat, die jeweils ein vorbestimmtes Layoutmuster darauf aufweisen, die genannte zwischenverbindende Schaltung (6) eine Vielzahl von zweiten Verbindungseinrichtungen (6B) auf einer Oberfläche des genannten isolierenden Films hat, die angeordnet sind, um den genannten ersten Verbindungseinrichtungen zu entsprechen, und die genannten zweiten Verbindungseinrichtungen jeweils mit den genannten ersten Verbindungseinrichtungen so verbunden sind, daß sie die genannten Schaltungsblöcke mit der genannten Zwischenverbindungsschaltung verbinden.

3. Integrierte Halbleiterschaltungsvorrichtung nach einem der Ansprüche 1 und 2, dadurch gekennzeichnet, daß die genannten Schaltungsblöcke in Matrixart angeordnet sind und dieselbe vorbestimmte Größe haben.

4. Integrierte Halbleiterschaltungsvorrichtung, dadurch gekennzeichnet, daß sie umfaßt:

ein Halbleiterwafer (1), das eine Vielzahl von Schaltungsblöcken (2) hat, die darin gebildet sind, und einen defekten Schaltungsblock enthält, und einen Zwischenbereich (3), der auf dem genannten Halbleiterwafer zwischen den genannten Schaltungsblöcken gebildet ist und die genannten Schaltungsblöcke elektrisch voneinander isoliert;

einen flexiblen zwischenverbindenden Film, der einen flexiblen isolierenden Film (10) und eine zwischenverbindende Schaltung (6) umfaßt, die auf dem genannten flexiblen isolierenden Film gebildet ist; und

ein Reparaturchip (8), welches auf dem genannten defekten Schaltungsblock verbunden ist, welches genannte Reparaturchip eine Schaltung hat, die mit derjenigen des defekten Schaltungsblocks austauschbar ist,

wobei das genannte flexible zwischenverbindende Film, der auf dem genannten Halbleiterwafer plaziert ist, und das genannte Reparaturchip miteinander in Ausrichtung sind und die genannte zwischenverbindende Schaltung mit den genannten Schaltungsblöcken und dem genannten Reparaturchip verbunden ist, um die genannte integrierte Halbleiterschaltungsvorrichtung zu vervollständigen, wobei die vorstehende obere Oberfläche des genannten Reparaturchips durch den genannten flexiblen zwischenverbindenden Film mit Hilfe der Verformung des genannten flexiblen isolierenden Films eingewikkelt ist.

5. Integrierte Halbleiterschaltungsvorrichtung nach Anspruch 4, dadurch gekennzeichnet, daß jeder der genannten Schaltungsblöcke (2) und das genannte Reparaturchip (8) eine Vielzahl von ersten Verbindungseinrichtungen (4, 9) haben, die in einem vorbestimmten Layoutmuster darauf angeordnet sind, wobei die genannte zwischenverbindende Schaltung (6), die auf dem genannten flexiblen isolierenden Film gebildet ist, eine Vielzahl von zweiten Verbindungseinrichtungen (6B, 11B) auf einer Oberfläche des genannten isolierenden Films, welche den genannten ersten Verbindungseinrichtungen entsprechen, hat, und die genannte korrespondierende erste Verbindungseinrichtungen und die genannte zweite Verbindungseinrichtungen miteinander verbunden sind, wodurch die genannten Schaltungsblöcke und das genannte Reparaturchip mit der genannten zwischenverbindenden Schaltung verbunden werden.

6. Integrierte Halbleiterschaltungsvorrichtung nach einem der Ansprüche 4 und 5, dadurch gekennzeichnet, daß die genannten Schaltungsblöcke und das genannte Reparaturchip in einer Matrixart angeordnet sind.

7. Integrierte Halbleiterschaltungsvorrichtung, dadurch gekennzeichnet, daß sie umfaßt:

ein Halbleiterwafer (1), das eine Vielzahl von Schaltungsblöcken hat, die darin gebildet sind, und einen defekten Schaltungsblock und einen Zwischenbereich (3) enthält, die in dem genannten Halbleiterwafer zwischen den genannten Schaltungsblöcken gebildet sind und die genannten Schaltungsblöcke elektrisch voneinander isolieren;

ein Reparaturchip (8), das mit dem genannten defekten Schaltungsblock verbunden ist, welches genannte Reparaturchip eine Schaltung aufweist, die mit derjenigen des genannten defekten austauschbar ist;

einen zwischenverbindenden Film, der einen isolierenden Film (15) umfaßt, und eine zwischenverbindende Schaltung (6), die darauf gebildet ist, welcher zwischenverbindende Film ein Loch (7) hat, das an dem Ort geöffnet ist, welcher dem genannten defekten Schaltungsblock in dem genannten Halbleiterwafer entspricht, welches genannte Loch eine Größe hat, die etwas größer als diejenige des Reparaturchip ist; und

einen Reparaturfilm, der einen isolierenden Film (20) und eine Vielzahl von Verbindungseinrichtungen (16A, 16B) hat, die auf einer Oberfläche des genannten isolierenden Films gebildet sind, um das genannte Reparaturchip mit der genannten zwischenverbindenden Schaltung (6) des genannten zwischenverbindenden Films zu verbinden,

wobei der genannte zwischenverbindende Film auf dem genannten Halbleiterwafer in Ausrichtung mit den genannten Blöcken des genannten Halbleiterwafers plaziert ist, und die genannte zwischenverbindende Schaltung darauf mit den genannten Schaltungsblöcken des genannten Halbleiterwafers verbunden ist, mit Ausnahme des genannten Reparaturchip, und der genannte Reparaturfilm auf dem genannten Reparaturchip in Ausrichtung damit plaziert ist, um das genannte Reparaturchip mit der genannten zwischenverbindenden Schaltung zu verbinden.

8. Integrierte Halbleiterschaltungsvorrichtung nach Anspruch 7, dadurch gekennzeichnet, daß jeder der genannten Schaltungsblöcke und das genannte Reparaturchip eine Vielzahl von ersten Verbindungseinrichtungen (4, 9) haben, die in einem ersten vorbestimmten Layoutmuster angeordnet sind,

die genannte zwischenverbindende Schaltung auf dem genannten isolierenden Film eine Vielzahl von zweiten Verbindungseinrichtungen (6B) hat, die in dem genannten ersten vorbestimmten Layoutmuster angeordnet sind, welches den genannten ersten Verbindungseinrichtungen entspricht, und eine Vielzahl von dritten Verbindungseinrichtungen (6A) in einem zweiten vorbestimmten Layoutmuster angeordnet sind, wobei jede der beiden genannten Verbindungseinrichtungen mit einer entsprechenden der genannten dritten Verbindungseinrichtungen verbunden ist,

jede der genannten Verbindungseinrichtungen, die auf dem genannten Reparaturfilm gebildet sind, eine vierte Verbindungseinrichtung (16A), eine fünfte Verbindungseinrichtung (16B) und einen Halbleiter umfaßt, der die genannte vierte Verbindungseinrichtung mit der genannten fünften Verbindungseinrichtung verbindet, wobei die vierte Verbindungseinrichtung in dem genannten ersten vorbestimmten Layoutmuster angeordnet ist und die genannte fünfte Verbindungseinrichtung in dem genannten zweiten vorbestimmten Layoutmuster angeordnet ist,

die genannten zweiten Verbindungseinrichtungen mit den genannten entsprechenden ersten Verbindungseinrichtungen (4) verbunden sind, so daß die Schaltungsblöcke mit der genannten zwischenverbindenden Schaltung verbunden werden,

die genannten vierten Verbindungseinrichtungen (16A) mit den genannten entsprechenden ersten Verbindungseinrichtungen (9) des genannten Reparaturchips verbunden sind, die genannten fünften Verbindungseinrichtungen (16B) mit den genannten dritten Verbindungseinrichtungen (6A) verbunden sind.

9. Integrierte Halbleiterschaltungsvorrichtung nach einem der Ansprüche 7 und 8, dadurch gekennzeichnet, daß die genannten Schaltungsblöcke und das genannte Reparaturchip in einer Matrixart angeordnet sind.

10. Integrierte Halbleiterschaltungsvorrichtung nach einem der Ansprüche 7 bis 9, dadurch gekennzeichnet, daß die genannte zwischenverbindende Verdrahtung (6) lediglich auf einem Abschnitt der genannten Oberfläche des genannten isolierenden Films, welcher dem genannten Zwischenbereich des Wafers zugewandt ist, gebildet ist.

11. Integrierte Halbleiterschaltungsvorrichtung nach einem der Ansprüche 8 bis 10, dadurch gekennzeichnet, daß der genannte Reparaturfilm eine Vielzahl der genannten Verbindungseinrichtungen hat, die jedem von allen Schaltungsblöcken des genannten Halbleiterwafer entsprechen.

12. Integrierte Halbleiterschaltungsvorrichtung nach einem der vorhergehenden Ansprüche, dadurch gekennzeichnet, daß der genannte isolierende Film (5; 10; 15) aus einer makromolekularen Verbindung wie Polyimid besteht.

13. Integrierte Halbleiterschaltungsvorrichtung nach einem der vorhergehenden Ansprüche, dadurch gekennzeichnet, daß der genannte isolierende Film (5; 10; 15) transparent ist.

**Revendications**

1. Dispositif à semiconducteur du type circuit intégré, caractérisé en ce qu'il comprend:
une pastille semiconductrice (1) possédant plusieurs blocs de circuit (2) formés dans la pastille et une aire intermédiaire (3) formée dans ladite pastille semiconductrice entre lesdits blocs de circuit, qui isole électriquement lesdits blocs de circuit les uns des autres; et
une pellicule d'interconnexion comprenant une pellicule isolante (5; 10; 15) et un circuit d'interconnexion (6) formé sur une face de ladite pellicule isolante,
ladite pellicule d'interconnexion étant placée sur ladite pastille semiconductrice en alignement mutuel, et ledit circuit d'interconnexion étant connecté auxdits blocs de circuit si bien que ledit dispositif à semiconducteur de type circuit intégré se trouve ainsi achevé.

2. Dispositif à semiconducteur du type circuit intégré selon la revendication 1, caractérisé en ce que chacun desdits blocs de circuit (2) possède plusieurs premiers moyens de liaison (4) portant une configuration de tracé prédéterminée, ledit circuit d'interconnexion (6) possède plusieurs deuxièmes moyens de liaison (6B) se trouvant sur une face de ladite pellicule isolante et disposés de manière à correspondre auxdits premiers moyens de liaison, et lesdits deuxièmes moyens de liaison sont respectivement connectés auxdits premiers moyens de liaison correspondants, de manière à ainsi connecter lesdits blocs de circuit audit circuit d'interconnexion.

3. Dispositif à semiconducteur du type circuit intégré selon la revendication 1 ou 2, caractérisé en ce que lesdits blocs de circuit sont disposés de manière matricielle et possèdent la même taille prédéterminée.

4. Dispositif à semiconducteur du type circuit intégré, caractérisé en ce qu'il comprend:
une pastille semiconductrice (1) possédant plusieurs blocs de circuit (2) formés sur la pastille, qui contiennent un bloc de circuit défectueux, et une aire intermédiaire (3) formée sur ladite pastille semiconductrice entre lesdits blocs de circuit, qui isole électriquement lesdits blocs de circuit les uns des autres;
une pellicule d'interconnexion souple comprenant une pellicule isolante souple (10) et un circuit d'interconnexion (6) formé sur ladite pellicule isolante souple; et
une puce de réparation (8) connectée sur ledit bloc de circuit défectueux, ladite puce de réparation possédant un circuit qui vient en remplacement de celui dudit bloc de circuit défectueux,
ladite pellicule d'interconnexion souple étant placée sur ladite pastille semiconductrice et ladite puce de réparation en alignement mutuel, et ledit circuit d'interconnexion étant connecté auxdits blocs de circuit et à ladite puce de réparation si bien que ledit dispositif à semiconducteur de type circuit intégré se trouve ainsi achevé, la surface supérieure saillante de ladite puce de réparation étant envelopée par ladite pellicule d'interconnexion souple du fait de la déformation de ladite pellicule isolante souple.

5. Dispositif à semiconducteur du type circuit intégré selon la revendication 4, caractérisé en ce que chacun desdits blocs de circuit (2) et chaque puce de réparation (8) possède plusieurs premiers moyens de liaison (4, 9) disposés suivant une configuration de tracé prédéterminée, ledit circuit d'interconnexion (6) formé sur ladite pellicule isolante souple possède plusieurs deuxièmes moyens de liaison (6B, 11B) se trouvant sur une face de ladite pellicule isolante en correspondance avec lesdits premiers moyens de liaison, et lesdits premiers moyens de liaison correspondants et lesdits deuxièmes moyens de liaison sont connectés les uns aux autres, si bien qu'il y a connexion desdits blocs de circuit et de ladite puce de réparation audit circuit d'interconnexion.

6. Dispositif à semiconducteur du type circuit intégré selon la revendication 4 ou 5, caractérisé en ce que lesdits blocs de circuit et ladite puce de réparation sont disposés d'une manière matricielle.

7. Dispositif à semiconducteur du type circuit intégré, caractérisé en ce qu'il comprend:
une pastille semiconductrice (1) possédant plusieurs blocs de circuit (2) formés sur la pastille, qui contiennent un bloc de circuit défectueux, et une aire intermédiaire (3) formée sur ladite pastille semiconductrice entre lesdits blocs de circuit, qui isole électriquement lesdits blocs de circuit les uns des autres;

une puce de réparation (8) connectée sur ledit bloc de circuit défectueux, ladite puce de réparation possédant un circuit qui vient en remplacement de celui dudit bloc défectueux;

une pellicule d'interconnexion comprenant une pellicule isolante (15) et un circuit d'interconnexion (6) formé sur celleci, ladite pellicule d'interconnexion possédant un trou (7) ouvert à l'emplacement qui correspond audit bloc de circuit défectueux dans ladite pastille semiconductrice, ledit trou ayant une taille légèrement plus grande que celle de ladite puce de réparation; et

une pellicule de réparation comprenant une pellicule isolante (20) et plusieurs moyens de connexion (16A, 16B) formés sur une face de ladite pellicule isolante afin de connecter ladite puce de réparation audit circuit d'interconnexion (6) de ladite pellicule d'interconnexion,

ladite pellicule d'interconnexion étant placée sur ladite pastille semiconductrice en alignement avec lesdits blocs de circuit de ladite pastille semiconductrice, et ledit circuit d'interconnexion qui est sur celle-ci étant connecté auxdits blocs de circuit de ladite pastille semiconductrice à l'exception de ladite puce de réparation, ladite pellicule de réparation étant placée sur ladite puce de réparation en alignement avec celle-ci de manière à connecter ladite puce de réparation audit circuit d'interconnexion.

8. Dispositif à semiconducteur du type circuit intégré selon la revendication 7, caractérisé en ce que chacun desdits blocs de circuit et chaque puce de réparation possède plusieurs premiers moyens de liaison (4, 9) disposés suivant une première configuration de tracé prédéterminée,

ledit circuit d'interconnexion formé sur ladite pellicule isolante possède plusieurs deuxièmes moyens de liaison (6B) disposés suivant ladite première configuration de tracé prédéterminée en correspondance avec lesdits premiers moyens de liaison, et plusieurs troisièmes moyens de liaison (6A) disposés suivant une deuxième configuration de tracé prédéterminée, chacun desdits deuxièmes moyens de liaison étant connecté à l'un, correspondant, desdits troisièmes moyens de liaison,

chacun desdits moyens de connexion formés sur ladite pellicule de réparation comprend un quatrième moyen de liaison (16A), un cinquième moyen de liaison (16B) et un conducteur connectant ledit quatrième moyen de liaison audit cinquième moyen de liaison, ledit quatrième moyen de liaison étant disposé suivant ladite première configuration de tracé prédéterminée et ledit cinquième moyen de liaison étant disposé suivant ladite deuxième configuration de tracé prédéterminée,

lesdits deuxièmes moyens de liaison (6B) sont connectés auxdits premiers moyens de liaison correspondants (4), si bien qu'il y a connexion des blocs de circuit avec ledit circuit d'interconnexion,

lesdits quatrièmes moyens de liaison (16A) sont connectés auxdits premiers moyens de liaison correspondants (9) de ladite puce de réparation, et

lesdits cinquièmes moyens de liaison (16B) sont connectés auxdits troisièmes moyens de liaison (6A).

9. Dispositif à semiconducteur du type circuit intégré selon la revendication 7 ou 8, caractérisé en ce que lesdits blocs de circuit et ladite puce de réparation sont disposés d'une manière matricielle.

10. Dispositif à semiconducteur du type circuit intégré selon la revendication 7, 8 ou 9, caractérisé en ce que ledit circuit d'interconnexion (6) n'est formé que sur la partie de ladite face de ladite pellicule isolante qui se trouve en face de ladite aire intermédiaire de ladite pastille.

11. Dispositif à semiconducteur du type circuit intégré selon l'une quelconque des revendications 8 à 10, caractérisé en ce que ladite pellicule de réparation possède plusieurs desdits moyens de connexion qui correspondent à chacun de tous les blocs de circuit de ladite pastille semiconductrice.

12. Dispositif à semiconducteur du type circuit intégré selon l'une quelconque des revendications précédentes, caractérisé en ce que ladite pellicule isolante (5; 10; 15) est faite d'un composé macromoléculaire tel que le polyimide.

13. Dispositif à semiconducteur du type circuit intégré selon l'une quelconque · des revendications précédentes, caractérisé en ce que ladite pellicule isolante (5; 10; 15) est transparente.

FIG. 1 PRIOR ART

FIG. 2 PRIOR ART

FIG. 4

FIG. 5

FIG. 8

## FIG. 3 (a)

## FIG. 3 (b)

A-A

## FIG. 6(a)

## FIG. 6(b)

## FIG. 7 (a)

## FIG. 7 (b)